# EUROPEAN PATENT APPLICATION

(11) **EP 4 163 687 A1**
(43) Date of publication of application: **12.04.2023**
(21) Application number: 21201127.4
(22) Date of filing: 06.10.2021
(51) Int. Cl.: G02B 6/42, G03F 7/20, G03F 9/00

(54) **FIBER ALIGNMENT MONITORING TOOL AND ASSOCIATED FIBER ALIGNMENT METHOD**

(71) Applicant: ASML Netherlands B.V., 5500 AH Veldhoven (NL)
(72) Inventor: KIM, Hyeok, 5500 AH Veldhoven (NL); KANG, Min, 5500 AH Veldhoven (NL)
(74) Representative: ASML Netherlands B.V.

(57) **Abstract**

Disclosed is fiber alignment monitoring tool for monitoring of beam alignment of a beam generated by a source module with respect to an optical fiber. The fiber alignment monitoring tool comprises a coupling arrangement for coupling the fiber alignment monitoring tool to a beam adjustment tool of said source module; and a beam alignment sensor operable to sense beam alignment and provide a beam alignment signal indicating beam alignment status, said beam alignment status describing a position status and/or angle status of said beam.

## Description

### FIELD OF INVENTION

The present invention relates to methods and apparatus usable, for example, in the manufacture of devices by lithographic techniques, and to methods of manufacturing devices using lithographic techniques. The invention relates more particularly to a fiber alignment monitoring tool for metrology sensors, and more particularly still to illumination arrangements for such metrology sensors.

### BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In some metrology applications, such as in some scatterometers or alignment sensors, it is important to ensure that the measurement radiation being coupled into an optical fiber for transportation to the metrology tool is properly aligned. This can be achieved in a fiber coupling phase in which a fiber coupling tool is adjusted for maximized laser power transmission into the optical fiber. Such fiber coupling adjustment may use a fiber alignment monitoring tool or electrical venturi tool. It would be desirable to improve such a fiber alignment monitoring tool and fiber coupling methods.

### SUMMARY OF THE INVENTION

The invention in a first aspect provides a fiber alignment monitoring tool for monitoring of beam alignment of a beam generated by a source module with respect to an optical fiber, the fiber alignment monitoring tool comprising: a coupling arrangement for coupling the fiber alignment monitoring tool to a beam adjustment tool of said source module; and a beam alignment sensor operable to sense beam alignment and provide a beam alignment signal indicating beam alignment status, said beam alignment status describing a position status and/or angle status of said beam.

Also disclosed is a method of aligning a beam generated by a source module with respect to an optical fiber, the method comprising: attaching a fiber alignment monitoring tool to a beam adjustment tool of said source module; and using the beam adjustment tool to align said beam in dependence of a beam alignment status obtained from said fiber alignment monitoring tool, said beam alignment status describing a position and/or angle of said beam.

The above and other aspects of the invention will be understood from a consideration of the examples described below.

### BRIEF DESCRIPTION OF THE DRAWINGS

Embodiments of the invention will now be described, by way of example only, with reference to the accompanying drawings, in which:
Figure 1 depicts a lithographic apparatus;
Figure 2 illustrates schematically measurement and exposure processes in the apparatus of Figure 1;
Figure 3 is a schematic illustration of an alignment sensor adaptable according to an embodiment of the invention;
Figure 4 is a schematic illustration of a fiber coupling arrangement (in cross section) where a beam of measurement radiation is coupled into an optical fiber;
Figure 5 is a schematic illustration of (a) a fiber coupled to a beam adjustment tool and (b) and (c) a prior art fiber alignment monitoring tool coupled to a beam adjustment tool;
Figure 6 is an exploded schematic illustration of a fiber alignment monitoring tool according to an embodiment; and
Figure 7 is an example visual representation of beam alignment in terms of (a) position and (b) angle which may be shown on the display of the fiber alignment monitoring tool of Figure 6.

### DETAILED DESCRIPTION OF EMBODIMENTS

Before describing embodiments of the invention in detail, it is instructive to present an example environment in which embodiments of the present invention may be implemented.

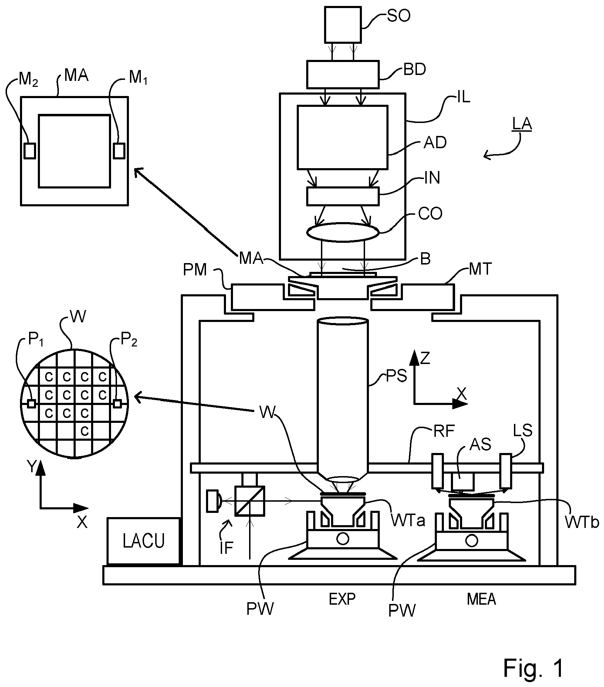

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

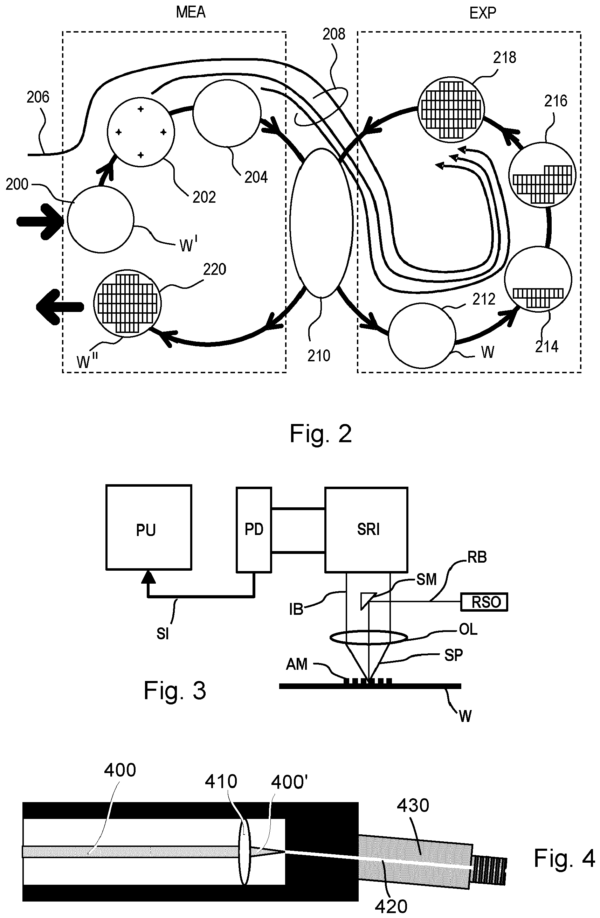

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and Ware swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

Figure 3 is a schematic block diagram of an embodiment of a known alignment sensor AS. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels are repeated at different wavelengths for increased accuracy and/or for robust detection of the mark irrespective of the materials from which the mark is made, and materials on and/or below which the mark is provided. Improvements in performing and processing such multiple wavelength measurements are disclosed below.

Metrology tools such as alignment sensors measure a target or mark using measurement radiation. Typically, the measurement radiation is generated by a source module (e.g., a laser module) and transported to the metrology device (e.g., into the sensor module) by means of a suitable optical fiber (e.g., a single-mode, polarization maintaining fiber). The source module may comprise a fiber coupling tool for coupling the generated radiation into the optical fiber. The fiber coupling tool (or other suitable device) may comprise a beam adjustment arrangement which enables the beam generated by the source module to be spatially adjusted (e.g., in position and/or angle) with respect to the optical fiber. This fiber adjustment may be performed in an initial fiber coupling phase where the fiber coupling tool is adjusted for maximized laser power transmission into the optical fiber. Such fiber coupling adjustment needs to be done each time a source module is connected, noting that e.g., a source module typically has a limited operation span between replacement or other maintenance action.

Figure 4 illustrates the coupling issue. A radiation beam 400 is generated by a source module (not shown); this beam 400 is focused (to form focused radiation 410') by a suitable lens or lens system 410 onto an input facet of an optical fiber core 420 (surrounded by fiber cladding/casing 430 etc.). It is this coupling of the focused beam 400' into the optical fiber 420 which is optimized such that the beam alignment (e.g., position and angle) with respect to the input facet is calibrated for good or optimal radiation transmission into the fiber core 420.

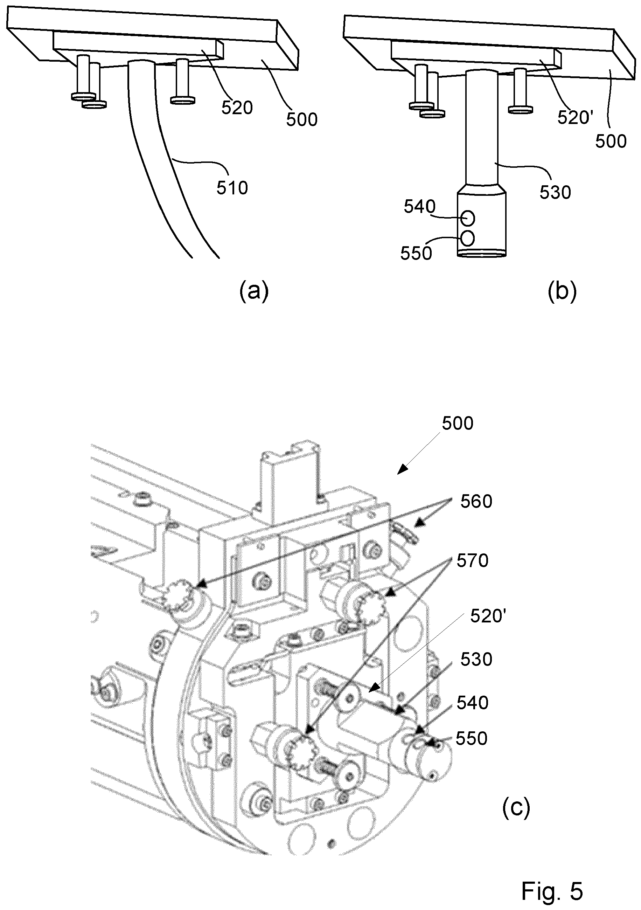

Figure 5(a) is a simplified schematic of an encased optical fiber 510 having a fiber coupling 520, via which it is coupled to a fiber coupling tool 500. The fiber coupling tool 500 has a number of adjustment screws 560, 570 (shown on Figure 5(c) only). Adjustment screws 560 enable beam position adjustment and adjustment screws 570 enable angle adjustment into the optical fiber. To monitor this adjustment, it is known to attach a fiber alignment monitoring tool (or venturi tool) in place of the optical fiber 510, as illustrated in simplified schematic Figure 5(b) and more detailed schematic Figure 5(c). The fiber alignment monitoring tool 530 comprises a similar fiber coupling 520' as the optical fiber and casing 510 to couple it to the fiber coupling tool 500. The fiber alignment monitoring tool 530 comprises two monitoring windows 540, 550; a first monitoring window 540 for monitoring beam position and a second monitoring window 550 for monitoring beam angle or tilt. Only when both of these windows are illuminated by the measurement radiation from the source is the beam properly adjusted.

However this type of fiber alignment monitoring tool does not provide the calibration engineer with any information as to where and at what angle the beam is being projected when misaligned, nor in which direction and/or by how much the beam should be adjusted. The consequence of this is that it takes a considerable amount of time to properly adjust the beam.

To address this issue, an improved fiber alignment monitoring tool, for monitoring of beam alignment into an optical fiber, is proposed. The improved fiber alignment monitoring tool comprises at least a beam alignment sensor operable to sense beam alignment and provide a feedback beam alignment signal indicating the present alignment status (e.g., beam position and angle with respect to the fiber input facet) of the beam. The beam position and angle may be displayed visually; for example with respect to a target position and angle.

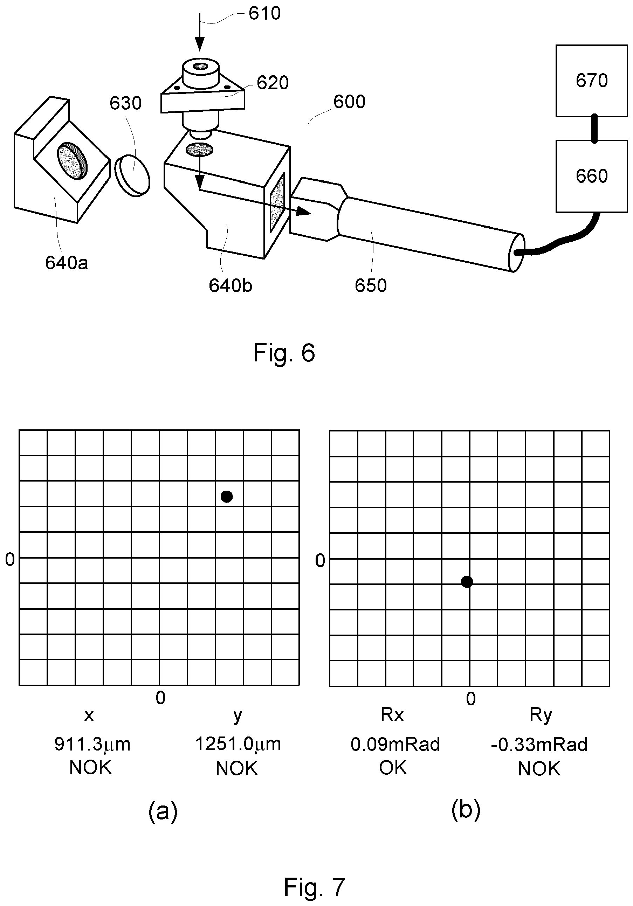

Figure 6 is a schematic exploded illustration of such an improved fiber alignment monitoring tool 600. The fiber alignment monitoring tool 600 may comprise a fiber coupling arrangement 620, which may be similar to fiber coupling 520, 520' so that it can be connected to a fiber coupling tool in a similar manner to a prior art fiber alignment monitoring tool 530. An input beam 610 is directed via a mirror 630 into a beam alignment sensor 650 or beam position and angle sensor. The beam alignment signal from beam alignment sensor 650 is sent to a processor 660 connected to a display 670. The fiber coupling arrangement 620, mirror 630 and beam alignment sensor 650 may be housed (at least partially) within a housing 640a, 640b.

An example of a suitable beam alignment sensor may comprise the sensor marketed as the "*Alignmeter USB"* by DUMA Optronics Ltd..

Figure 7 is an example of the visual beam alignment information as may be displayed on display 670. The display may show (a) a first beam alignment grid or beam position grid and (b) a second beam alignment grid or beam angle grid. On each grid is a visual representation (e.g., black dot as illustrated) of the beam's present position and angle respectively. The beam position may be shown on a grid, for which its origin (e.g., center position) may represent the target position/angle. Obviously the target position/angle may be represented in other ways than being the origin of a grid, or may be not shown at all (e.g., the optimal position/angle may be known by the user). Optionally, positions and angles may be shown numerically (alternatively or in addition to a grid representation). Also optionally, an OK/NOK indicator may indicate whether the position or angle (for each respective coordinate) is aligned sufficiently well (OK) or not (NOK). The position and angle may be displayed to the user in real time (or close to), such that the effect of each adjustment is quickly fed back to the user as they adjust the beam alignment. It will also be apparent from the display in which direction and by how much the beam should be adjusted. Of course, a visual display is only one method of conveying the feedback beam alignment signal, other methods (alternatively or in addition) may comprise providing this feedback audibly or by any other suitable means.

In another embodiment, such a device may provide for fully automated fiber alignment. In such an embodiment, the processor 560 may be connected to adjustment actuators under control of the processor, such that the processor actuates adjustment of the beam position and angle (e.g., via adjustment screws 560, 570 or otherwise) so as to automatically align the beam to the target position and angle based on the signal from the beam alignment sensor 650. In such an embodiment, a display 670 may not be necessary.

It is expected that such a fiber alignment monitoring tool can significantly reduce the fiber coupling adjustment time; e.g., from the order of multiple hours as presently typical to the order of minutes.

While the disclosed fiber alignment monitoring tool is described in the specific application example of beam coupling alignment into a fiber for an alignment sensor, it may be used for beam coupling alignment of any metrology device (e.g., a scatterometer based device) which uses measurement radiation transported to the metrology device by optical fiber.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A fiber alignment monitoring tool for monitoring of beam alignment of a beam generated by a source module with respect to an optical fiber, the fiber alignment monitoring tool comprising:
a coupling arrangement for coupling the fiber alignment monitoring tool to a beam adjustment tool of said source module; and
a beam alignment sensor operable to sense beam alignment and provide a beam alignment signal indicating beam alignment status, said beam alignment status describing a position status and/or angle status of said beam.

2. A fiber alignment monitoring tool as claimed in claim 1, wherein said beam alignment sensor is operable such that beam alignment signal indicates said beam alignment status in real time during adjustment of said beam alignment.

3. A fiber alignment monitoring tool as claimed in claim 1 or 2, comprising a display for displaying said beam alignment status to a user.

4. A fiber alignment monitoring tool as claimed in claim 3, wherein said display is operable to display a visual representation of one or more target values for said beam alignment, and to display said beam alignment status in relation to said visual representation of one or more target values.

5. A fiber alignment monitoring tool as claimed in any preceding claim, wherein said display is operable to display each of said position and/or angle on a respective displacement grid.

6. A fiber alignment monitoring tool as claimed in any preceding claim, wherein said beam alignment status comprises beam position status and beam angle status.

7. A fiber alignment monitoring tool as claimed in any preceding claim, wherein said source module comprises a measurement radiation source module for providing measurement radiation for a metrology device.

8. A fiber alignment monitoring tool as claimed in any preceding claim, comprising a processor operable to receive the beam alignment signal and provide said beam alignment status to a user.

9. A fiber alignment monitoring tool as claimed in claim 8, wherein the processor is operable to generate actuation signals to adjustment actuators under control of the processor, such that the processor actuates adjustment of said beam alignment so as to automatically align the beam.

10. A fiber alignment monitoring tool as claimed in any preceding claim, wherein said coupling arrangement is configured to couple to the fiber alignment monitoring tool in place of the optical fiber during a beam adjustment phase.

11. A fiber alignment monitoring tool as claimed in any preceding claim, comprising a mirror for directing said beam into said beam alignment sensor.

12. A fiber alignment monitoring tool as claimed in any preceding claim, comprising a housing for at least partially housing said fiber coupling arrangement and beam alignment sensor.

13. A method of aligning a beam generated by a source module with respect to an optical fiber, the method comprising:
attaching a fiber alignment monitoring tool to a beam adjustment tool of said source module; and
using the beam adjustment tool to align said beam in dependence of a beam alignment status obtained from said fiber alignment monitoring tool, said beam alignment status describing a position and/or angle of said beam.

14. A method as claimed in claim 13, wherein said fiber alignment monitoring tool comprises a fiber alignment monitoring tool as claimed in any of claims 1 to 12.

15. A method as claimed in claim 13 or 14, wherein said beam alignment status comprises beam position status and beam angle status.

16. A method as claimed in claim 13, 14 or 15, comprising referring to a visual representation of said beam alignment status in said step of aligning said beam.

17. A method as claimed in any of claims 13 to 16, wherein said source module comprises a measurement radiation source module for providing measurement radiation for a metrology device, such that said beam comprises a beam of measurement radiation.

18. A method as claimed in claim 17, wherein said metrology device is an alignment sensor within a lithography apparatus, and the optical fiber comprises an optical fiber for transporting the measurement radiation to the alignment sensor.
